# EUROPEAN PATENT APPLICATION

(11) **EP 0 636 715 A1**
(43) Date of publication of application: **01.02.1995**
(21) Application number: 94305541.8
(22) Date of filing: 27.07.1994
(51) Int. Cl.: C30B 29/22, C30B 17/00, H01L 39/24

(54) **Composite seed material**

(30) Priority: 27.07.1993 JP 184713/93
(71) Applicant: INTERNATIONAL SUPERCONDUCTIVITY TECHNOLOGY CENTER, Tokyo 105 (JP); HITACHI CABLE, LTD., Chiyoda-ku Tokyo 100 (JP); THE HOKKAIDO ELECTRIC POWER COMPANY INC., Sapporo-shi Hokkaido (JP); KYUSHU ELECTRIC POWER CO., INC, Fukuoka-ken (JP); THE KANSAI ELECTRIC POWER CO., INC., Osaka 530-70 (JP); FUJIKURA LTD., Koto-ku Tokyo (JP)
(72) Inventor: Yamada, Yasuji, Tokyo (JP); Nakamura, Masaru, Mitaka-shi, Tokyo (JP); Tatsumi, Noriyuki, Tokyo (JP); Tsujino, Jiro, Tokyo (JP); Ohtsu, Kanshi, Musashino-shi, Tokyo (JP); Kanamori, Yasuo, Tokyo (JP); Tagami, Minoru, Funabashi-shi, Chiba-ken (JP); Kume, Atsushi, Tokyo (JP); Shiohara, Yuh, Chigasaki-shi, Kanagawa-ken (JP); Tanaka, Shoji, City Cope 103, Tokyo (JP)
(74) Representative: Allam, Peter Clerk

(57) **Abstract**

A composite seed material is disclosed which includes a substrate, and an oriented film provided on a surface of the substrate and formed of a metal oxide which has a crystal structure of a Y123 metal oxide and which has the formula LnBa₂Cu₃O_{y} wherein Ln stands for Y or an element belonging to the lanthanoid and y is a number of 6-7. The seed material is useful for growing a layer of a Y123 metal oxide crystal thereon.

## Description

This invention relates to a composite seed material suitable for growing a layer of a metal oxide having a Y123 crystal thereon.

One known method for the preparation of a metal oxide crystal having a Y123 crystal structure includes contacting a seed material with a molten mixture of metal oxides to allow the desired crystal to grow on the seed material. The term Y123 crystal structure" used in the present specification and claims is intended to refer to a crystal structure similar to that of YBa₂Cu₃O₇₋ₓ where x is a number of 0-1. The term "Y123 metal oxide" is intended to refer to a metal oxide having a Y123 crystal structure.

As the seed crystal, a magnesia single crystal, a Sm123 metal oxide crystal or a Y123 metal oxide crystal has been hitherto used. The magnesia single crystal seed, however, has a problem that a crystal which has grown thereon forms a Y123 polycrystal rather than a single Y123 crystal. The Y123 crystal seed, on the other hand, poses a problem that the molten mixture climbs along the seed crystal so that a holder thereof will be wetted and reacted with the molten mixture.

It is, therefore, an object of the present invention to provide a seed material which is suitable for forming a Y123 single crystal thereon.

Another object of the present invention is to provide a seed material of the above-mentioned type which can prevent a molten metal oxide mixture, with which the seed material is contacted for the growth of the Y123 crystal, from climbing along the seed crystal.

In accomplishing the foregoing objects, there is provided in accordance with one aspect of the present invention a composite material comprising a substrate, and an oriented film provided on a surface of said substrate and formed of a metal oxide which has a crystal structure of a Y123 metal oxide and which has the formula:

LnBa₂Cu₃O_{y}

wherein Ln stands for Y or an element belonging to the lanthanoid and y is a number of 6-7.

Other objects, features and advantages of the present invention will become apparent from the detailed description of the preferred embodiments of the invention which follows, when considered in light of the accompanying drawings, in which:
Fig. 1 is a schematic illustration of a composite seed material according to the present invention used for growing a Y123 metal oxide crystal thereon;
Fig. 2 is an X-ray diffraction pattern of a metal oxide layer of the composite seed material obtained in Example 1 according to the present invention; and
Fig. 3 is a cross-sectional, elevational view diagrammatically showing an apparatus useful for the growth of a Y123 metal oxide crystal on a seed material of the present invention.

The seed material according to the present invention is a composite material composed of a substrate, and an oriented film provided on a surface of the substrate and formed of a metal oxide which has a Y123 crystal structure and has a composition expressed by the formula:

LnBa₂Cu₃O_{y}

wherein Ln stands for Y or an element belonging to the lanthanoid (including La, Ce, Pr, Nd, Pm, Sm, Eu, Gd, Tb, Dy, Ho, Er, Tm, Yb and Lu) and y is a number of 6-7.

The substrate is preferably formed of a material which is substantially unwettable with a melt composed of Ba, Cu and O. Examples of suitable substrates include oxides containing an alkaline earth metal, such as alkaline earth metal oxides. The use of a MgO crystal is particularly preferred.

Whether or not the substrate is wettable may be determined as follows:

A sample having a length of 50 mm, a thickness of 3 mm and a width of 15 mm is immersed by a depth of 5 mm for 15 hours in a melt of a mixture of BaO and CuO (Ba/Cu molar ratio of 3:7) contained in a 10 ml crucible, with the longitudinal axis of the sample being oriented normal to the surface of the melt. The melt is maintained at 1,050°C. When the distance through which the melt climbs along the sample after 15 hours immersion is not greater than 5 mm, then the sample is regarded as being unwettable.

The oriented film of a Y123 crystal is provided over a surface of the substrate. The direction of the orientation of the film is not specifically limited. For example, an oriented film whose c-axis is oriented in the direction normal to the plane of the substrate or whose a-axis is oriented in the direction normal to the plane of the substrate may be suitably used.

When the seed material has an a-axis oriented film, a layer of a crystal which is grown thereon is also a-axis oriented. Thus, the use of a seed material having an a-axis oriented film is advantageous in the preparation of a good quality SIS junction, since the thickness of the I-layer can be made nearly equal to the coherence length of the S-layer.

The thickness of the oriented film of a Y123 metal oxide crystal is preferably 0.01-1 µm. The crystallinity of a Y123 crystal layer grown on the oriented film generally depends upon the thickness of the oriented film. Thus, a thickness of the oriented film greater than 1 µm is not preferable since the Y123 crystal layer tends to form a polycrystal. Too small a thickness below 0.01 µm also results in the formation of a polycrystal.

The oriented film may be easily formed on the substrate by a plasma deposition method in which a raw material oxide powder of Ln-Ba-Cu-O is fed into a high frequency plasma to vaporize same and to permit the vapors to deposit on a surface of the substrate.

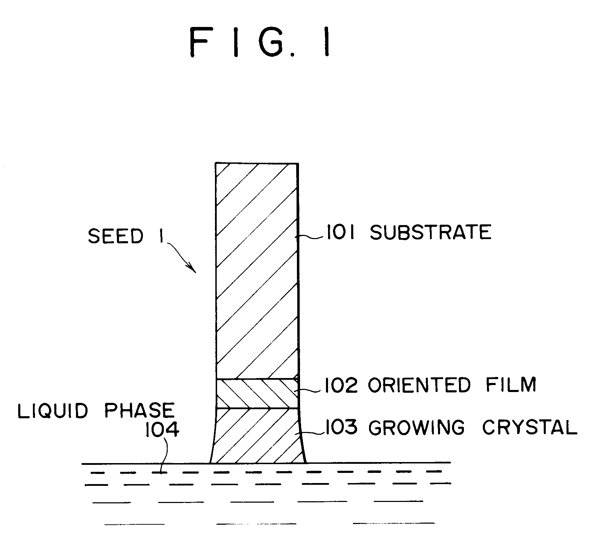

The thus obtained composite material is suitably used as a seed material for the formation of a layer of a Y123 metal oxide crystal thereon. Such a Y123 crystal layer may be suitably obtained in a manner as shown in Fig. 1. Thus, the composite seed material 1 which is composed of a substrate 101 and an oriented film 102 of a Y123 crystal is contacted with a melt 104 of a mixture of metal oxides containing solutes which constitute the Y123 crystal under conditions so that the Y123 crystal layer 103 is grown as primary crystals. In this case, even when the oriented film of the seed material is not completely oriented, the Y123 crystal grown thereon has good crystallinity and crystal orientation.

More particularly, the formation of the Y123 crystal layer on the seed material may be suitably performed by a method including a step of contacting the oriented film with a liquid phase which contains a melt composed of Ba, Cu and O and in which a solid phase is present at a position separated by the liquid phase from the position at which the oriented film contacts the liquid phase, the solid phase providing the liquid phase with solutes which constitute the desired Y123 metal oxide crystal so that the solutes are transported to the position at which the oriented film and the liquid phase contact, thereby permitting the desired metal oxide crystal to grow on the seed material as primary crystals.

The solid phase to be used in the method of the present invention is preferably a Y-series 211 metal oxide. The term "Y-series 211 metal oxide" used in the present specification and claims is intended to refer to a metal oxide having the formula:

Ln₂BaCuO₅₋ₓ

wherein Ln has the same meaning as above and x is a number of 0-1.

As the liquid phase, any desired metal oxide mixture may be used. Generally, a melt composed of Cu, Ba and O is used. Such a liquid phase may be obtained by admixing at least two oxide sources selected from a source of copper oxide, a source of barium oxide and a source of BaCu oxide to form an admixture, the admixture being subsequently heated at a temperature of, for example, 880°C for 40 hours. In this case, it is desirable that the molar ratio of Ba to Cu should be 3:5 to 3:8.

The weight ratio of the liquid phase to the solid phase is preferably 2-10 parts by weight per part by weight of the solid phase.

The solid phase and the liquid phase are contained in a crucible formed of a material which does not react with the liquid phase and which does not adversely affect the properties of the desired metal oxide crystal, such as yttria, magnesia, alumina or stabilized zirconia. The crucible is placed within a furnace or oven. The seed material is immersed in the liquid phase while gradually lowering the temperature of the liquid phase so as to cause the crystal of the desired Y123 metal oxide to deposit on the seed material and to grow. For the acceleration of the growth of the crystal, the temperature of the liquid phase adjacent to the seed material is made lower by about 20°C at maximum than the pertectic temperature. In an alternative, the substrate is slowly pulled up at a rate of 0.01-10 mm per hour.

The following examples will further illustrate the present invention.

### Example 1

### Preparation of Seed Material:

A magnesia single crystal (substrate) in the form of a rod was heated so that the surface temperature was in the range of 600°-1,000°C. According to the plasma deposition method, a raw material oxide powder of Ln-Ba-Cu-O was vaporized and allow to deposit on the heated surface of the substrate. The substrate was then cooled to 300°C in the atmosphere of oxygen to form an oriented film on the cleavage plane of the substrate. The plasma deposition was performed under the conditions summarized in Table below.

Raw Material Powder
- Composition:: Y_{1.3}Ba_{2.2}Cu_{3.2}O_{7-d}
- Average particle diameter:: 2-3 µm
- Carrier Gas (feed rate):: Ar (2 liter/minute)
- Vacuum:: 200 torr
- High Frequency Power:: 32 kW
- Plasma Gas (feed rate):: Ar (2 liter/minute)
- Sheath Gas (feed rate):: O₂ (50 liter/minute)

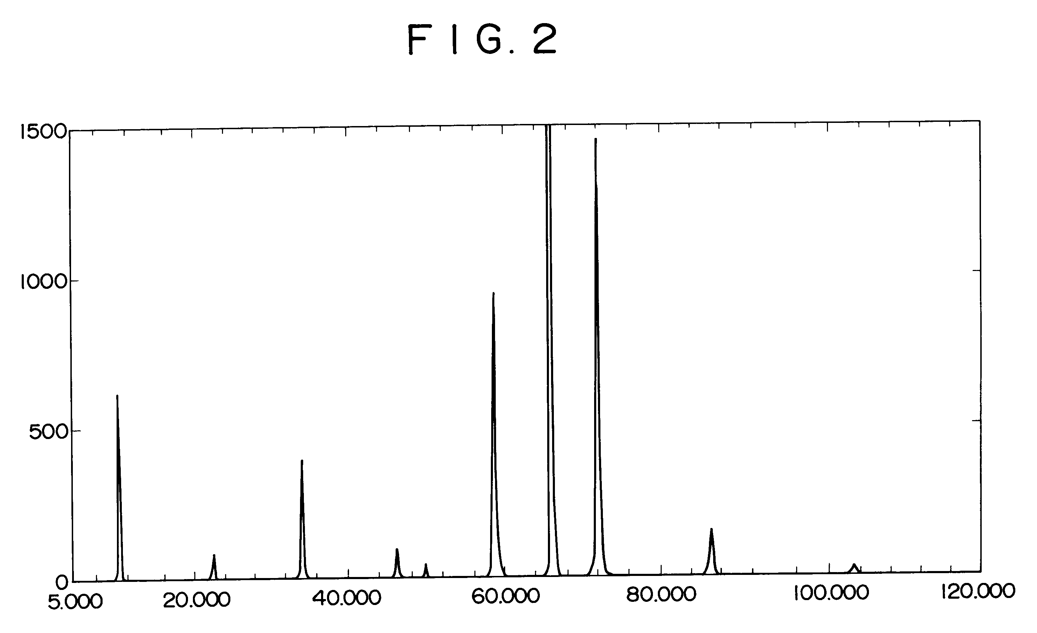

The X-ray diffraction pattern of the oriented film thus obtained is shown in Fig. 2. From the diffraction pattern, the c-axis of the oriented film is found to be oriented in the direction normal to the plane of the substrate. Some peaks oriented in the other directions also exist, suggesting that the orientation of the film is not uniform. The film was found to have a Y123 crystal structure.

### Formation of Y123 Crystal Layer:

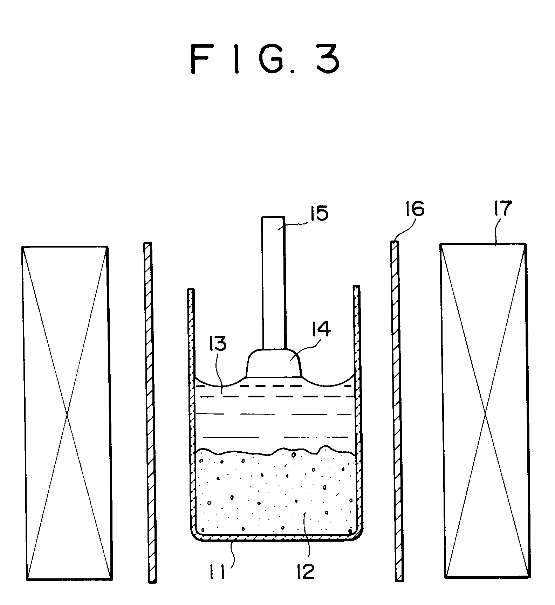

As shown in Fig. 3, into a yttria crucible 11 having an inside diameter of 30 mm and a height of 50 mm were charged Y₂BaCuO₅ (solid phase) 12 and a calcined mass (liquid phase) 13 obtained by calcining a mixture of barium carbonate and copper oxide (a molar ratio of Ba/Cu of 3:5) at 880°C for 40 hours. The crucible 11 was placed inside of a furnace having a platinum susceptor 16 and a high frequency coil 17 and the contents in the crucible 11 was heated to about 1,000°C to melt the mixture of BaO and CuO (liquid phase 13) beneath which the solid phase 12 was present. Then, the above seed material having the oriented film 14 formed on the cleavage plane of the magnesia single crystal 15 was contacted with the melt in the crucible and, after lowering the temperature of the crucible by 20°C, was continuously pulled up at a rate of 0.2 mm per hour for about 50 hours while being rotated at 100 revolutions per minute (rpm), whereby a single crystal of YBa₂Cu₃O₇₋ₓ was allowed to grow on the seed crystal bar as primary crystal.

The thus grown Y123 crystal layer had a mirror surface. The polarized microscope revealed that the Y123 crystal layer had good crystallinity and was free of grain boundaries though a twin plane was present.

## Claims

1. A composite seed material comprising a substrate, and an oriented film provided on a surface of said substrate and formed of a metal oxide which has a crystal structure of a Y123 metal oxide and which has the formula:
LnBa₂Cu₃O_{y}
wherein Ln stands for Y or an element belonging to the lanthanoid and y is a number of 6-7.

2. A seed material as set forth in claim 1, wherein said substrate is formed of a material which is substantially unwettable with a melt composed of Ba, Cu and O.

3. A seed material as set forth in claim 1, wherein said substrate is a crystal of a metal oxide containing an alkaline earth metal.

4. A seed material as set forth in claim 1, wherein said substrate is formed of a MgO crystal.

5. A seed material as set forth in claim 1, wherein said oriented film has been formed by a plasma deposition method.
